# EUROPEAN PATENT APPLICATION

(11) **EP 2 808 420 A1**
(43) Date of publication of application: **03.12.2014**
(21) Application number: 14170337.1
(22) Date of filing: 28.05.2014
(51) Int. Cl.: C23C 14/56, H01L 21/285, H01J 37/34, H01J 37/32

(54) **Sputtering apparatus**

(30) Priority: 30.05.2013 KR 20130061497
(71) Applicant: Samsung SDI Co., Ltd., Yongin-si, Gyeonggi-do (KR)
(72) Inventor: Park, Jae-bum, Gyeonggi-do (KR); Park, Bo-Hwan, Gyeonggi-do (KR); Kang, Eui-Jung, Gyeonggi-do (KR)
(74) Representative: Walaski, Jan Filip

(57) **Abstract**

A sputtering apparatus (100a) for depositing a deposition material on a substrate (200), the sputtering apparatus including a chamber (110), a target (120) in the chamber, the target including the deposition material; and a shield (130a) between the substrate and an inner wall of the chamber, the shield including a plurality of sub-shields (131, 132, 133).

## Description

The present invention relates to a sputtering apparatus.

As energy demands increase, demands on solar cells for converting solar energy into electrical energy also increase. Solar cells are clean energy sources that produce electricity from the sun as an almost infinite energy source. Solar cells have come into the spotlight as a new growth engine with a high industrial growth rate every year.

Embodiments are directed to a sputtering apparatus.

The embodiments may be realized by providing a sputtering apparatus for depositing a deposition material on a substrate, the sputtering apparatus including a chamber; a target in the chamber, the target including a deposition material; and a shield between the substrate and an inner wall of the chamber, the shield including a plurality of sub-shields.

The sputtering apparatus may further include an auxiliary chamber extending at sides of the chamber, the auxiliary chamber being in communication with the chamber.

The shield may include a first sub-shield between a lower side of the substrate and the inner wall of the chamber; a second sub-shield that is movable between the auxiliary chamber and the chamber; and a third sub-shield at sides of the first sub-shield, the third sub-shield being between the first sub-shield and the inner wall of the chamber.

The sputtering apparatus may further include a first driver, the first driver moving the movable second sub-shield between the auxiliary chamber and the chamber.

When the second sub-shield is in the chamber, the second sub-shield may be in an overlapping relationship with the third sub-shield.

At least one sub-shield among the plurality of sub-shields may be foldable along bending lines.

The plurality of sub-shields may be in an overlapping relationship and between the inner wall of the chamber and the substrate.

Each of the sub-shields may be wider than the substrate such that each of the sub-shields covers the inner wall of the chamber below the substrate.

The shield may include a fourth sub-shield that is foldable along the bending lines; and a fifth sub-shield between the fourth sub-shield and the inner wall of the chamber.

The sputtering apparatus may further include a second driver that folds or unfolds the foldable fourth sub-shield.

At least one sub-shield among the plurality of sub-shields may be windable.

The plurality of sub-shields may be in an overlapping relationship and between the inner wall of the chamber and the substrate.

Each of the sub-shields may be wider than the substrate such that each of the sub-shields covers the inner wall of the chamber below the substrate.

The shield may include a sixth sub-shield that is windable; and a seventh sub-shield between the sixth sub-shield and the inner wall of the chamber.

The sputtering apparatus may further include a third driver that winds or unwinds the windable sixth sub-shield.

The sixth sub-shield may have a mesh form.

Features will be apparent to those of skill in the art by describing in detail exemplary embodiments with reference to the attached drawings in which:
FIG. 1 illustrates a schematic view of a sputtering apparatus according to an embodiment.
FIG. 2 illustrates a schematic view of a comparative sputtering apparatus.
FIGS. 3 and 4 illustrate schematic views of stages in an operating method of the sputtering apparatus shown in FIG. 1.
FIGS. 5 and 6 illustrate schematic views of a sputtering apparatus according to another embodiment.
FIG. 7 illustrates a perspective view of a sub-shield portion of the sputtering apparatus shown in FIG. 5.
FIGS. 8 and 9 illustrate schematic views of a sputtering apparatus according to still another embodiment.
FIG. 10 illustrates a perspective view of a sub-shield portion of the sputtering apparatus shown in FIG. 8.

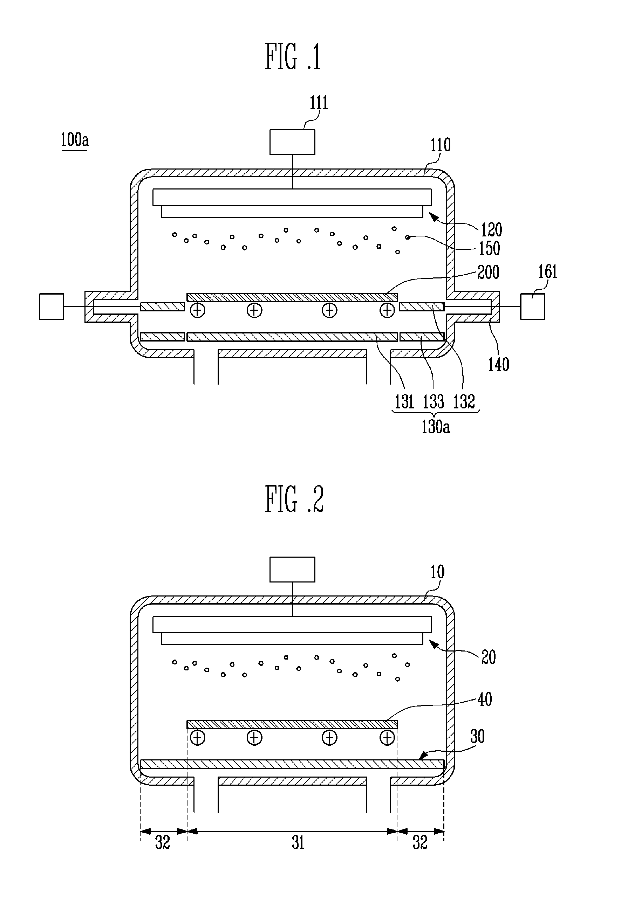

Hereinafter, the sputtering apparatus 100a according to an embodiment will be described with reference to FIG. 1.

As shown in FIG. 1, the sputtering apparatus 100a includes a chamber 110, a target 120, and a shield 130a. The shield 130a may include a plurality of sub-shields 131, 132, and 133, also referred to as subsidiary shields or as a shield unit comprising a plurality of shields. A portion, e.g., one, of the sub-shields 131, 132, and 133 may move between the chamber 110 and an auxiliary chamber 140.

The chamber 110 may be a space in which a sputtering process is performed. For example, the target 120, the shield 130a, and a substrate 200 may be placed inside the chamber 110.

Here, a vacuum state may be maintained in the chamber 110 so that the sputtering process may be smoothly performed. For example, a gas supplier and a vacuum pump may be connected to the chamber 110. Accordingly, the vacuum state in the chamber 110 may be maintained.

A power source 111 may be connected to the chamber 110 at an outside of the chamber 110. Accordingly, plasma 150 may be generated between the substrate 200 and the target 120.

The target 120 may be arranged to receive a deposition material; for example it may comprise a deposition material 122 on a deposition material support structure 121. The deposition material 122 may be transferred from the deposition material support structure 121 onto the substrate 200 through a sputtering process.

For example, the target 120 may be placed at an upper portion of the chamber 120. The target 120 may be fixed to the chamber 110 by, e.g., a support or the like. Meanwhile, the target 120 may be connected to the power source 111 so as to have a negative polarity. Accordingly, the target 120 may collide with ions in the chamber 110, which may be generated by acceleration of electrons, so that parts of the deposition material 122 may be separated from a surface of the target 120. The deposition material 122 may be deposited in the form of a thin film on the surface of the substrate 200 (that has a positive polarity).

In this case, the substrate 200 may be placed at a lower portion of the chamber 110. The substrate 200 may be fixed to the chamber 110 by, e.g., a support or the like. The substrate 200 may be grounded to have the positive polarity. Accordingly, the deposition material 122 that is separated from the surface of the target portion 120 may be deposited on the substrate 200.

The sputtered deposition material may move in more than one direction, i.e., may move in directions other than toward the substrate 200. Thus, unless otherwise prevented from doing so, the deposition material may be grown or deposited on the surface of the substrate 200 as well as on other surfaces, e.g., an exposed inner wall of the chamber 110. If the deposition material is not prevented from being grown or deposited on the inner wall of the chamber 110, the inside of the chamber 110 may be contaminated. For example, the deposition material grown or deposited on the inner wall of the chamber 110 may gradually receive stress or otherwise be separated from the inner wall of the chamber 110. Therefore, the separated deposition material, e.g., flying in the form of dust inside the chamber 110, may be undesirably attached a portion of a substrate 200. Accordingly, reducing the likelihood and/or preventing the deposition material of the target portion 120 from being grown or deposited on the inner wall of the chamber 110 may be very desirable.

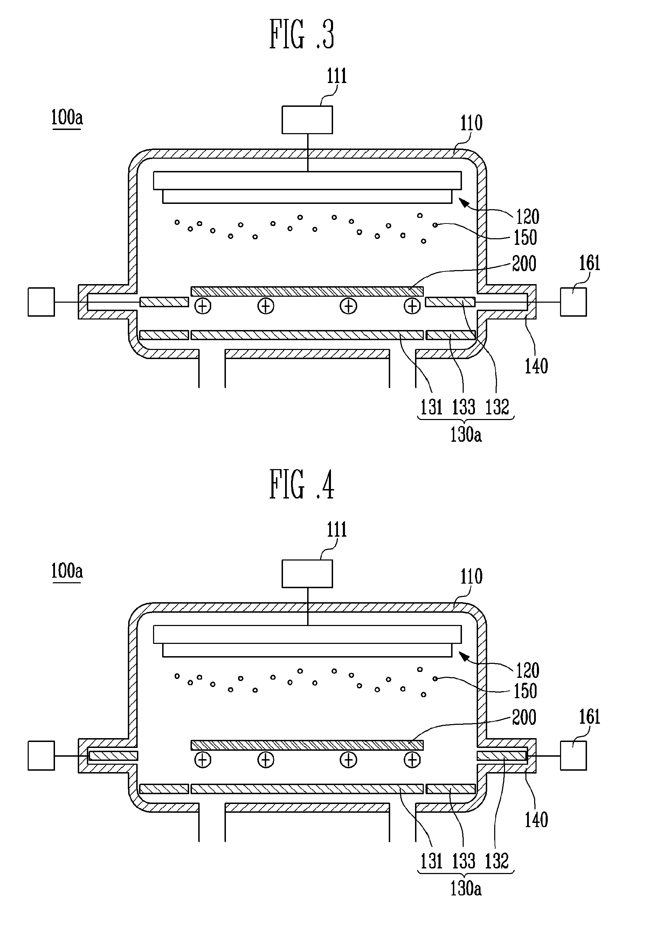

FIG. 2 illustrates a schematic view of another type of sputtering apparatus. FIGS. 3 and 4 illustrate schematic views of stages in an operating method of the sputtering apparatus 100a shown in FIG. 1. Hereinafter, the sputtering apparatus 100a according to an embodiment will be described in detail with reference to FIGS. 2 to 4.

Referring to FIG. 2, in a solar cell, a glass substrate may be used as a substrate 40, and a deposition material from a target 20 may be accumulated in a relatively large amount at a lower portion of a chamber 10 due to free-fall motion of free parts of the deposition material. Therefore, a shield 30 may be mounted between an inner wall of the chamber and the substrate 40, as shown in FIG. 2. However, if the shield 30 (formed as shown in FIG. 2) is used for a certain period of time, the deposition material may be grown or deposited on a surface of the shield 30. Therefore, it may be necessary for the shield 30 to be cleansed in order to be reused. The substrate 40 may cover a first region 31 of the shield 30, e.g., a portion of the shield 30 underlying the substrate 40, and hence an amount of the deposition material grown or deposited on the first region 31 may be relatively small. However, a second region 32 of the shield 30, e.g., at an outside of the substrate 40 or beyond outer edges of the substrate 40, may directly face the target 20. Thus, the amount of the deposition material grown or deposited on the second region 32 of the shield 30 may be relatively large. Therefore, the shield 30 may be required to be cleansed very frequently due to, e.g., the deposition material accumulated on the second region 32. In order to be cleaned, it may be required for the shield 30 to be extracted from the chamber 10, and thus the vacuum state in the chamber 10 may be frequently broken. As a result, it may take a relatively large amount of effort, time, and cost to cleanse the shield 30 by, e.g., breaking the vacuum state in the chamber 10, reloading the shield 30 in the chamber 10, and then achieving and maintaining the vacuum state of the chamber 10.

However, as shown in FIGS. 3 and 4, the sputtering apparatus 100a according to an embodiment may further include the shield 130a that has the plurality of sub-shields 131, 132, and 133, and the auxiliary chamber 140 that provides a space in which a second sub-shield 132 of the shield 130a may be moved. Accordingly, it is possible to reduce the likelihood of and/or prevent the drawbacks described above.

As noted above, the shield 130a may include the plurality of sub-shields 131, 32, and 133 between the substrate 200 and the inner wall of the chamber 110. For example, the shield 130a may include a first sub-shield 131, the second sub-shield 132, and a third sub-shield 133. In an implementation, the first sub-shield 131 may be between a lower portion or side of the substrate 200 and the inner wall of the chamber 100. For example, an area of the first sub-shield 131 may be about equal to or smaller than that of the substrate 200. Thus, the deposition material 122 separated from the target 120 may grow or be deposited in only a relatively small amount on the first sub-shield 131, due to the substrate 200 covering or overlying the first sub-shield 131. In addition, the third sub-shield 133 may be at sides, e.g., outer sides, of the first sub-shield 131, i.e., between the first sub-shield 131 and the inner wall, e.g., inner side wall, of the chamber 110. Accordingly, the first sub-shield 131 may help protect the inner wall (e.g., a lower outer side or part of the inner wall of the chamber 110) of the chamber 110 from the deposition material, which may not otherwise be covered due to its relatively small area. If only the third sub-shield 133 were present, the deposition material could be continuously deposited in a large amount on the third sub-shield 133. However, according to an embodiment, the second sub-shield 132 may help reduce and/or prevent such excess deposition.

For example, the second sub-shield 132 may extend at sides of the chamber 110, and may freely move between the chamber 110 and the auxiliary chamber 140 (that is in communication with the chamber 110). For example, the second sub-shield 132 may be placed in the chamber 110 (as shown in FIG. 3), and may be moved to the auxiliary chamber 140 (as shown in FIG. 4). In the sputtering apparatus 100a, the second sub-shield 132 may be initially placed or disposed in the chamber 110 (as shown in FIG. 3), so that it is possible to protect a lower inner wall of the chamber 110 with the second sub-shield 132 (on which second sub-shield 132 the deposition material may be grown or deposited in a relatively large amount). Subsequently, when the deposition material is deposited on the second sub-shield 132 in a predetermined, desired, or sufficiently large amount, the second sub-shield 132 may be replaced. For example, the second and third sub-shields 132 and 133 may form a double-layered structure such that when the second sub-shield 132 gets covered with a desired, predetermined, or sufficiently large amount of deposition material, it may be moved to the auxiliary chamber 140 (or otherwise out of the way), and the third sub-shield 133 may then serve to protect inner walls of the chamber 110.

Thus, the lower inner wall of the chamber 110 may be protected from the deposition material in the chamber 110 by using the third sub-shield 133, e.g., after the second sub-shield 132 is moved to the auxiliary chamber 140 (as shown in FIG. 4). For example, the second sub-shield 132 may be implemented as a drawer-type sub-shield, so that it is possible to extend an overall replacement time of the shield 130a, e.g., to increase an interval between replacements or to decrease a frequency of replacement of the shield 130a. In an implementation, the second sub-shield 132 may be formed as a single-layered structure or may be formed as a multi-layered structure. For example, it is possible to further extend the replacement time of the shield 130 as a number of movable second sub-shields 132 increases.

Meanwhile, when the second sub-shield 132 is moved into the auxiliary chamber 140, the third sub-shield 133 may be in a position (corresponding to that which the second sub-shield 132 had been placed in the chamber 110) in order to protect the inner wall of the chamber 110. For example, the third sub-shield 133 may be below, e.g., may underlie, the second sub-shield 132, when the second sub-shield 132 is in the chamber 110 (as shown in FIG. 3). In an implementation, moving the second sub-shield 132 may be manually performed. In another implementation, moving the second sub-shield 132 may be automatically performed using a first driver 161, e.g., a motor.

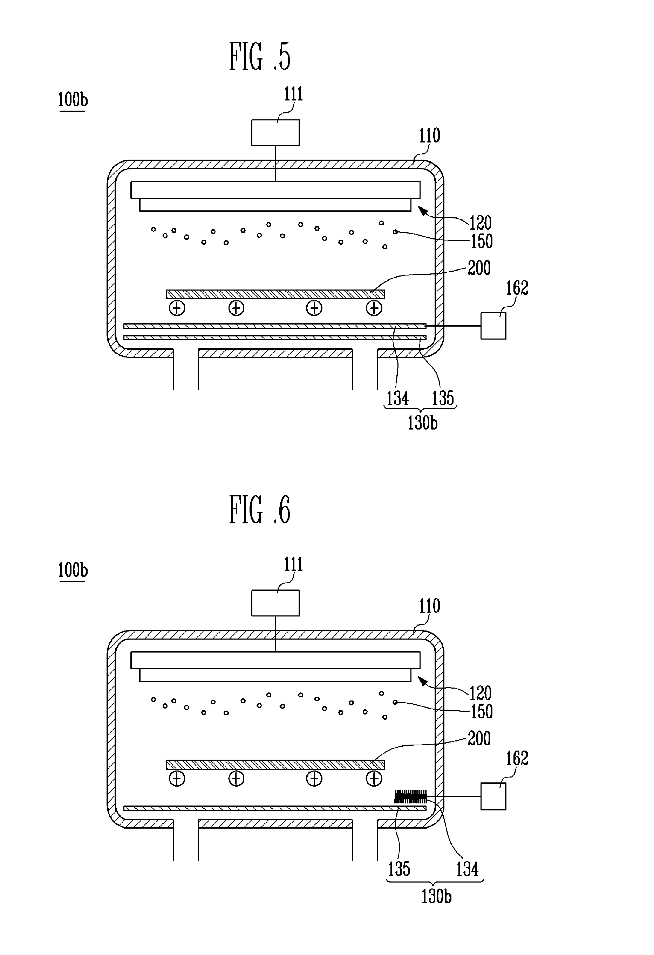

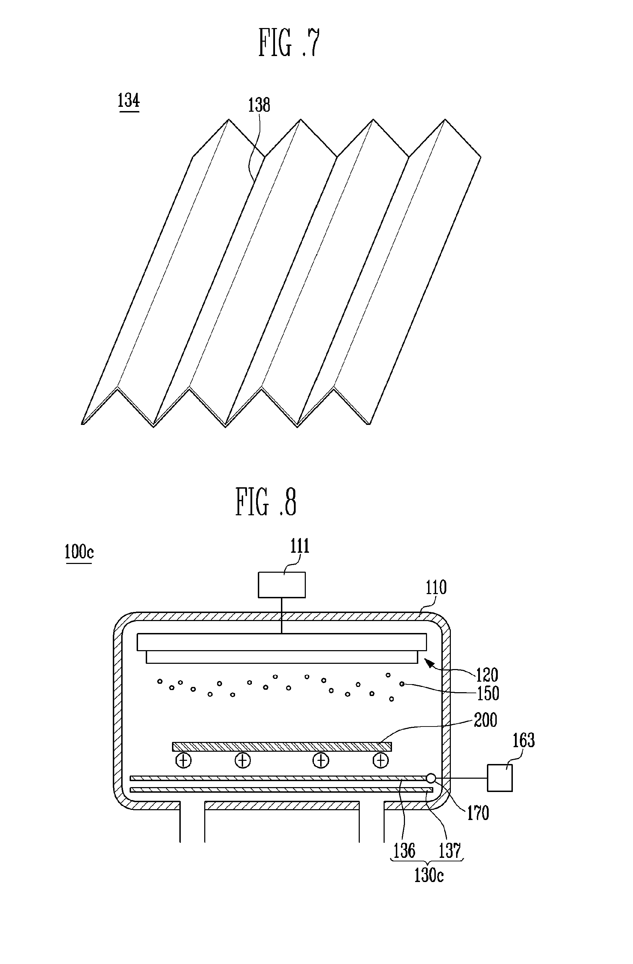

FIGS. 5 and 6 illustrate schematic views of a sputtering apparatus 100b according to another embodiment. FIG. 7 illustrates a perspective view of a sub-shield 134 of the sputtering apparatus 100b shown in FIG. 5. Hereinafter, the sputtering apparatus 100b according to the present embodiment will be described with reference to FIGS. 5 to 7.

The sputtering apparatus 100b according to the present embodiment may include a chamber 110, a target 120, and a shield 130b. The shield 130b may include a plurality of sub-shields 134 and 135. At least one sub-shield, e.g., a fourth sub-shield 134, among the plurality of sub-shields 134 and 135 may be folded or foldable along bending lines 138. For example, the fourth sub-shield 134 may be folded out of the way when it is no longer needed or when a sufficiently large amount of deposition material grows or is deposited thereon.

For example, the bending lines 138 may be formed in the fourth sub-shield 134, as shown in FIGS. 5 to 7. Accordingly, the fourth sub-shield 134 may be folded, e.g., like an accordion, along the bending lines 138. Thus, in a state in which the fourth sub-shield 134 is unfolded, the inner wall of the chamber 110, e.g., the lower inner wall of the chamber 110, may be covered by the fourth sub-shield 134. In a state in which the fourth sub-shield 134 is folded, e.g., out of the way, the lower inner wall of the chamber 110 may not be covered by the fourth sub-shield 134, but may be covered by the other, e.g., fifth sub-shield. The sub-shields 134 and 135 may be placed in a layered form or structure, e.g., may overlap one another, between the substrate 200 and the inner wall of the chamber 110. The sub-shields 134 and 135 may be wider than the substrate 200, so that the inner wall of the chamber 110 may be sufficiently protected from the deposition material when the fourth sub-shield 134 is unfolded or is folded out of the way.

An operating method of the sputtering apparatus 100b according to the present embodiment will be described with reference to FIGS. 5 and 6. First, a fourth sub-shield 134 (disposed relatively higher than the fifth sub-shield 135, e.g., such that the fourth sub-shield 134 is between the target 120 and the fifth sub-shield 135) may be initially unfolded as shown in FIG. 5. Subsequently, when the deposition material grows or is deposited on the fourth sub-shield 134 in a predetermined, desired, or sufficiently large amount, the fourth sub-shield 134 may be replaced. For example, the fourth sub-shield 134 may be folded along the bending lines 138 as shown in FIG. 6, e.g., out of the way, so that the inner wall of the chamber 110 may be protected using the fifth sub-shield 135. Thus, it is possible to extend the replacement time of the shield 130b. Accordingly, it is possible to implement reduction in effort, cost, and time. In an implementation, the fifth sub-shield 135 may be foldable, may be initially unfolded, or may only be unfolded when the fourth sub-shield 134 is folded out of the way. In an implementation, the fifth sub-shield 135 may be a sub-shield disposed most adjacent to the inner wall of the chamber 110. Thus, the fifth sub-shield 135 may not need to be folded. Therefore, the fifth sub-shield 135 may not be required to be foldable. In an implementation, the fourth sub-shield 134 may have a single-layered structure or may have a multi-layered structure. Accordingly, it is possible to further extend the replacement time of the shield 130b, e.g., further reduce the replacement frequency.

In an implementation, the fourth sub-shield 134 may be manually folded or unfolded. In another implementation, the fourth sub-shield 134 may be folded or unfolded through a separate second driver 162, e.g., a motor.

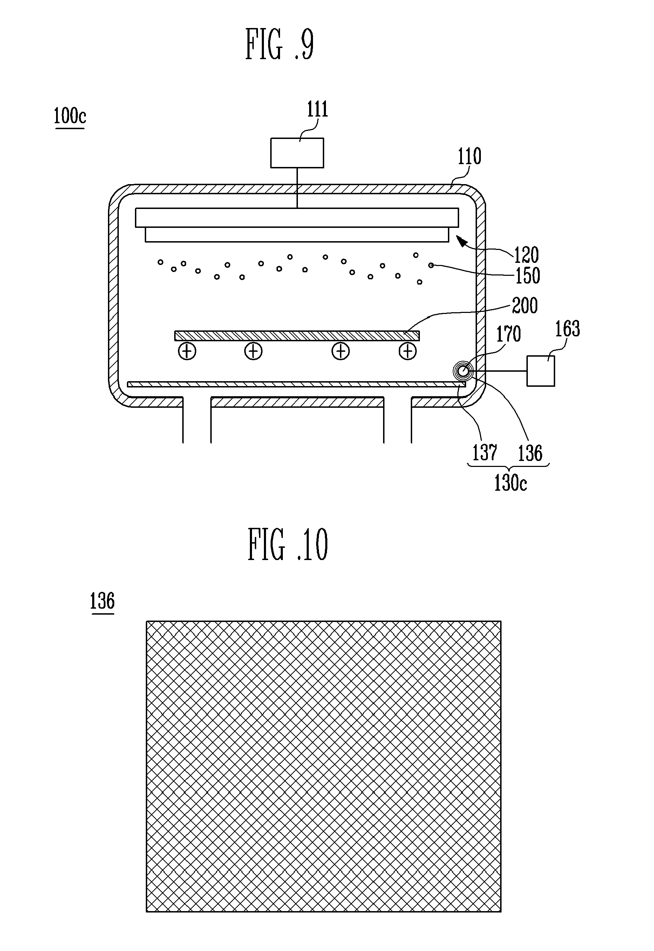

FIGS. 8 and 9 illustrate schematic views of a sputtering apparatus 100c according to still another embodiment. FIG. 10 illustrates a perspective view showing a sub-shield 136 of the sputtering apparatus 100c shown in FIG. 8. Hereinafter, the sputtering apparatus 100c according to the present embodiment will be described with reference to FIGS. 8 to 10.

The sputtering apparatus 100c according to the present embodiment may include a chamber 110, a target 120, and a shield 130c. The shield 130c may include a plurality of sub-shields 136 and 137. At least one sub-shield, e.g., a sixth sub-shield 136, among the plurality of sub-shields 136 and 137 may be wound or unwound, e.g., windable.

For example, the sixth sub-shield 136 may be implemented as, e.g., a flexible mesh form as shown in FIGS. 8 to 10. Accordingly, the sixth sub-shield 136 may be wound around a core material 170. Thus, in a state in which the sixth sub-shield 136 is unwound, the lower inner wall of the chamber 110 may be covered by the sixth sub-shield 136. In a state in which the sixth sub-shield 136 is wound, the lower inner wall of the chamber 110 may not be covered by the sixth sub-shield 136. In an implementation, the sub-shields 136 and 137 may be placed in a layered form or structure, e.g., may overlap with one another, between the substrate 200 and the inner wall of the chamber 110. The sub-shields 136 and 137 may be wider than the substrate 200, so that the inner wall of the chamber 110 may be sufficiently protected from the deposition material when the sixth sub-shield 136 is unwound or wound.

An operating method of the sputtering apparatus 100c according to the present embodiment will be described with reference to FIGS. 8 and 9. First, the sixth sub-shield 136 may be placed relatively higher than a seventh sub-shield portion 137, e.g., such that the sixth sub-shield 136 is between the target 120 and the seventh sub-shield 137. The sixth sub-shield 136 may be initially unwound as shown in FIG. 8. Subsequently, when the deposition material grows or is deposited on the sixth sub-shield 136 in a predetermined, desired, or sufficiently large amount, the sixth sub-shield 136 may be replaced. For example, the sixth sub-shield 136 may be wound as shown in FIG. 9, e.g., out of the way, so that the inner wall of the chamber 110 may be protected using the seventh sub-shield 137. Thus, it is possible to extend the replacement time of the shield 130c. Accordingly, it is possible to implement reduction in effort, cost, and time.

For example, the seventh sub-shield 137 may be foldable or windable, may be initially unfolded or unwound, or may be unfolded or unwound only when the sixth sub-shield 136 is wound, e.g., out of the way. The seventh sub-shield 137 may be a shield that is disposed most adjacent to the inner wall of the chamber 110. Thus, the seventh sub-shield 137 may not need to be folded or wound, e.g., may not need to be foldable or windable. In an implementation, the sixth sub-shield 136 may have a single-layered structure or a multi-layered structure. In this case, it is possible to further lengthen the time between replacements of the shield 130c, e.g., to reduce the replacement frequency of the shield 130c.

In an implementation, the sixth sub-shield 136 may be manually wound or unwound. In another implementation, the sixth sub-shield 136 may be wound or unwound through a separate third driver 163, e.g., a motor.

By way of summation and review, in the solar cell, a glass substrate may be used as a substrate. In this case, an electrode layer or the like may be deposited in the form of a thin film on the glass substrate. A method for forming the thin film may be broadly divided into chemical vapor deposition (CVD) and physical vapor deposition (PVD).

A sputtering apparatus may be used to deposit the thin film. The sputtering apparatus may grow a deposition material on a substrate by separating the deposition material from a target, e.g., using ions accelerated by plasma. The sputtering apparatus may form a thin film over a short period of time through a relatively simple structure. Thus, the sputtering apparatus is widely used.

However, in a case where the sputtering apparatus is used, the deposition material may also be grown in a chamber, etc., in addition to the substrate. The deposition material may contaminate an interior of the chamber.

The embodiments provide a sputtering apparatus that may help prevent an interior of a chamber from being contaminated, e.g., may help prevent a deposition material from being grown or deposited on an inner wall of the chamber.

According to an embodiment, the inner wall of the chamber may be covered with the shield including a plurality of sub-shields, so that it is possible to prevent the inside of the chamber from being contaminated by, e.g., a deposition material grown or deposited on the inner wall of the chamber.

According to an embodiment, the second sub-shield may be implemented as a drawer-type sub-shield, so that it is possible to extend a lifespan of the shield, thereby reducing cost and time spent in a process using the sputtering apparatus.

According to an embodiment, the fourth sub-shield may be implemented to be folded or unfolded, e.g., foldable, so that it is possible to extend the lifespan of the shield.

According to an embodiment, the sixth sub-shield may be implemented to be wound or unwound, e.g., windable, so that it is possible to extend the lifespan of the shield. Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A sputtering apparatus for depositing a deposition material on a substrate, the sputtering apparatus comprising:
a chamber;
a target in the chamber, the target being arranged to receive the deposition material; and
a shield between the substrate and an inner wall of the chamber, the shield including a plurality of sub-shields.

2. The sputtering apparatus as claimed in claim 1, further comprising an auxiliary chamber extending at sides of the chamber, the auxiliary chamber being in communication with the chamber.

3. The sputtering apparatus as claimed in claim 2, wherein the shield includes:
a first sub-shield between a lower side of the substrate and the inner wall of the chamber;
a second sub-shield that is movable between the auxiliary chamber and the chamber; and
a third sub-shield at sides of the first sub-shield, the third sub-shield being between the first sub-shield and the inner wall of the chamber.

4. The sputtering apparatus as claimed in claim 3, further comprising a first driver, the first driver moving the movable second sub-shield between the auxiliary chamber and the chamber.

5. The sputtering apparatus as claimed in claim 3 or 4, wherein, when the second sub-shield is in the chamber, the second sub-shield is in an overlapping relationship with the third sub-shield.

6. The sputtering apparatus as claimed in any one of the preceding claims, wherein at least one sub-shield among the plurality of sub-shields is foldable along bending lines.

7. The sputtering apparatus as claimed in claim 6, wherein the plurality of sub-shields are in an overlapping relationship and between the inner wall of the chamber and the substrate.

8. The sputtering apparatus as claimed in claim 6 or 7, wherein the shield includes:
a fourth sub-shield that is foldable along the bending lines; and
a fifth sub-shield between the fourth sub-shield and the inner wall of the chamber.

9. The sputtering apparatus as claimed in claim 8, further comprising a second driver that folds or unfolds the foldable fourth sub-shield.

10. The sputtering apparatus as claimed in any one of the preceding claims, wherein at least one sub-shield among the plurality of sub-shields is windable.

11. The sputtering apparatus as claimed in claim 10, wherein the plurality of sub-shields are in an overlapping relationship and between the inner wall of the chamber and the substrate.

12. The sputtering apparatus as claimed in any one of the preceding claims, wherein each of the sub-shields is wider than the substrate such that each of the sub-shields covers the inner wall of the chamber below the substrate.

13. The sputtering apparatus as claimed in claim 10, 11 or 12, wherein the shield includes:
a sixth sub-shield that is windable; and
a seventh sub-shield between the sixth sub-shield and the inner wall of the chamber.

14. The sputtering apparatus as claimed in claim 13, further comprising a third driver that winds or unwinds the windable sixth sub-shield.

15. The sputtering apparatus as claimed in claim 13 or 14, wherein the sixth sub-shield has a mesh form.
